# EUROPEAN PATENT SPECIFICATION

(11) **EP 2 662 905 B1**
(45) Date of publication and mention of the grant of the patent: **12.08.2015**
(21) Application number: 13166878.2
(22) Date of filing: 07.05.2013
(51) Int. Cl.: H01L 31/18

(54) **Method and system to control the printing pressure on a substrate**
Verfahren und System zur Kontrolle des Drucks in einem Druckprozess auf einem Substrat
Procédé et système pour controller la pression d'un procédé d'impression sur un substrat

(30) Priority: 09.05.2012 IT UD20120082; 26.11.2012 US 201261729887 P
(43) Date of publication of application: 13.11.2013
(73) Proprietor: APPLIED MATERIALS ITALIA S.R.L., 31048 San Biagio di Callalta (TV) (IT)
(72) Inventor: De Santi, Luigi, 31027 Spresanio Treviso (IT); Ruffo, Alberto Emilio, 31032 Casala Sul Sile Treviso (IT)
(74) Representative: Zimmermann & Partner Patentanwälte mbB

(56) References cited:
- JP-A- 2005 186 619
- US-A1- 2006 124 003
- US-A1- 2007 048 448
- US-A1- 2009 058 915

## Description

### BACKGROUND OF THE INVENTION

### Field of the Invention

Embodiments of the present invention generally relate to a method and to a system used to control the printing pressure on a substrate or support which can be used to form a photovoltaic (PV) device or a green-tape type circuit device.

Embodiments of the present invention may provide a system for printing a pattern on a substrate using a printing device, whether it be by silk-screen printing, ink-jet printing, laser printing or any other suitable type of printing.

### Description of the Related Art

Solar cells are PV devices that convert sunlight directly into electrical power. The PV market has experienced growth at annual rates exceeding 30% for the last ten years. Some articles suggest that solar cell power production world-wide may exceed 10 GWp in the near future. It is estimated that more than 95% of all solar modules are silicon wafer based. The high market growth rate in combination with the need to substantially reduce solar electricity costs has resulted in a number of serious challenges for inexpensively forming high quality solar cells. Therefore, one major component in making commercially viable solar cells lies in reducing the manufacturing costs required to form the solar cells by improving the device yield and increasing the substrate throughput. Document US2006/124003A discloses method to manufacture solar cells.

Methods for producing solar cells and configuring solar cells with one or more p-n junctions are well known. Each p-n junction comprises two different regions within a semiconductor material where one side is denoted as the p-type region and the other as the n-type region. When the p-n junction of a solar cell is exposed to sunlight consisting of energy from photons, the sunlight is directly converted to electricity through the PV effect. Solar cells generate a specific amount of electric power and are tiled into modules sized to deliver the desired amount of system power. Solar modules are joined into panels with specific frames and connectors. Solar cells are commonly formed on silicon substrates, which may be single or multicrystalline silicon substrates. A typical solar cell includes a silicon wafer, substrate, or sheet typically less than about 0.3 mm thick with a thin layer of an n-type silicon on top of a p-type region formed on the substrate.

Generally, a standard silicon solar cell is fabricated on a wafer which includes a p-type base region, an n-type emitter region, and a p-n junction region disposed therebetween. An n-type region, or n-type semiconductor, is formed by doping the semiconductor with certain types of elements (*e.g*., phosphorous (P), arsenic (As) or antimony (Sb)), in order to increase the number of negative charge carriers, *i.e.* electrons. Similarly, a p-type region, or p-type semiconductor, is formed by the addition of trivalent atoms to the crystal lattice, resulting in a missing electron from one of the four covalent bonds normal for the silicon lattice. Thus the dopant atom can accept an electron from a neighboring atoms covalent bond to complete the fourth bond. The dopant atom accepts an electron, causing the loss of half of one bond from the neighboring atom and resulting in the formation of a "hole."

When light falls on the solar cell, energy from the incident photons generates electron-hole pairs on both sides of the p-n junction region. Electrons diffuse across the p-n junction to a lower energy level, and holes diffuse in the opposite direction, creating a negative charge on the emitter and a corresponding positive charge builds up in the base. When an electrical circuit is made between the emitter and the base and the p-n junction is exposed to certain wavelengths of light, a current will flow. The electrical current generated by the semiconductor when illuminated flows through contacts disposed on the front side, i.e., the light-receiving side, and the backside of the solar cell. The top contact structure is generally configured as widely-spaced thin metal lines, or fingers, that supply current to larger bus bars. The back contact is generally not constrained to be formed in multiple thin metal lines, since it does not prevent incident light from striking solar cell. Solar cells are generally covered with a thin layer of dielectric material, such as Si₃N₄, to act as an antireflection coating, or ARC, to minimize light reflection from the top surface of the solar cell.

Screen printing has long been used in printing designs on objects, such as cloth or ceramics, and is used in the electronics industry for printing electrical component designs, such as electrical contacts or interconnects on the surface of a substrate. State of the art solar cell fabrication processes also use screen printing processes. In some applications, it is desirable to screen print contact lines, such as fingers, on the solar cell substrate. The fingers are in contact with the substrate and are adapted to form an Ohmic connection with one or more doped regions (e.g., n-type emitter region). An Ohmic contact is a region on a semiconductor device that has been prepared so that the current-voltage (I-V) curve of the device is linear and symmetric, i.e., there is no high-resistance interface between the doped silicon region of the semiconductor device and the metal contact. Low-resistance, stable contacts are critical for the performance of the solar cell and reliability of the circuits formed in the solar cell fabrication process.

A backside contact completes the electrical circuit required for solar cell to produce a current by forming an Ohmic contact with a p-type base region of the substrate.

Printing systems comprising a print station provided with at least a print head adapted to print a pattern on a substrate are known, for example, a wafer of a PV cell. In particular, the substrate is positioned on a printing nest which is moved from and toward the desired print station by means of a print shuttle. Each print head is provided with a blade adapted to distribute the print material, for example a conductive paste, uniformly on a printing net.

Each shuttle is taken near the print station to allow the printing operations to be carried out, and the blade is pressed and moved under pressure against the printing net and hence against the substrate to be printed.

In order to guarantee a correct and repeatable execution of the printing, the blade must exert pressure on the net, and hence on the surface of the substrate, at a determinate pressure which must be substantially the same on each of the substrates printed and on each shuttle that is taken each time in the printing position.

One known problem is that the print shuttles may have different heights from each other, which can differ even by some hundredths of a millimeter. The result of this difference in height is that subsequent printing operations may be carried out with different pressures exerted by the blade, and therefore the substrate may be printed in a non-repetitive manner and consequently with different electrical characteristics.

In order to overcome this problem, it is known to execute the printing operations in pressure control mode, by setting a pressure value that the blade exerts on the printing net, and consequently on the substrate.

More specifically, detectors are associated to the print head, so as to directly or indirectly detect the pressure with which the latter is pressed against the surface to be printed; the blade is moved toward the printing net and when the blade contacts the printing net to start the printing step, it is pressed against the latter until the set value of pressure is reached.

One disadvantage of this known method is that, when the blade contacts the surface of the substrate, and is therefore moved and grazes the surface of the substrate, the blade does not reach the set pressure instantaneously. Consequently, at least in the initial and final print portions, that is, the zones where the blade firstly contacts and then detaches from the surface of the substrate, printing imperfections arise due to a variation in the value of pressure of the blade on the surface.

Another printing method is known which provides to execute the printing operations in pressure control mode by setting a value of the position of the print head with respect to the surface of the substrate being printed. In this case, the blade is always positioned at the same height with respect to the substrate support surface and in a pre-determined position such that a printing pressure is reached that allows for adequate quality prints. However, this method has the disadvantage that it is not possible to guarantee an adequate printing repeatability of different substrates, given that the distance between the print head and the surface of the substrate can vary, due to dimensional tolerances of the thickness of each substrate and due to different heights of the print shuttles.

Therefore, there is a need to achieve a method and a system to control the printing on a substrate adapted to obtain a printed pattern with a desired quality and repeatability on substrates disposed on different print shuttles, which are moved one after the other into correspondence with the print head.

There is also a need to improve a method and a system to control the printing on a substrate that is simple and economical to implement in a printing system.

### SUMMARY OF THE INVENTION

In one embodiment, a method to control the printing pressure on a substrate, comprises performing at least a first printing operation on a first substrate with a printing apparatus that is disposed relative to a first print shuttle, which has a substrate supporting surface that is disposed at a first position, wherein the first printing operation is performed at a first printing pressure, and performing at least a second printing operation on a second substrate disposed on a substrate supporting surface of a second print shuttle using the printing apparatus, wherein the second printing operation is performed when the substrate supporting surface of the second print shuttle is disposed at a second position, and is performed at a second printing pressure. If a deviation is detected between the second printing pressure and the first printing pressure, the position of the printing apparatus relative to the second position is changed to match the second printing pressure to the first printing pressure.

In another embodiment, a printing system comprises a first print shuttle that has a substrate supporting surface that is disposed at a first position, a second print shuttle that has a substrate supporting surface that is disposed at a second position, one or more position detectors configured to detect a position of a printing apparatus with respect to the substrate supporting surface of the first print shuttle; and a controller. The controller is configured to control a first printing operation using the printing apparatus when it is disposed relative to the substrate supporting surface of the first print shuttle, wherein the first printing operation is performed at a first printing pressure, and a second printing operation using the printing apparatus when it is disposed relative to the substrate supporting surface of the second print shuttle, wherein the second printing operation is performed at a second printing pressure. The controller is further configured to detect a deviation between the second printing pressure and the first printing pressure, and to change the position of the printing apparatus relative to the second position to match the second printing pressure to the first printing pressure.

### BRIEF DESCRIPTION OF THE DRAWINGS

So that the manner in which the above-recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.
Figure 1 is a schematic isometric view of one embodiment of a screen printing system;
Figure 2 is a schematic top plan view of the screen printing system of Figure 1;
Figure 3 is a schematic isometric view of one embodiment of a screen printing system;
Figure 4 is a schematic top plan view of the screen printing system of Figure 3;
Figure 5 is a schematic isometric view of one embodiment of a screen printing system;
Figure 6 is a schematic top plan view of the screen printing system of Figure 5;
Figure 7 is an isometric view of one embodiment of a printing nest;
Figure 8 is a schematic representation of one embodiment of a printing apparatus;
Figure 9 is a schematic representation of a detail of one embodiment of a printing apparatus;
Figure 10 is a schematic representation of one embodiment of printing conditions; and
Figure 11 is a schematic representation of one embodiment of printing apparatus.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

In one embodiment, a method to control a printing pressure on a substrate or substrate support can be used to form a PV device or a green-tape type circuit. The method is applied to control the printing pressure of a printing apparatus with respect to print shuttles that are taken into cooperation with the printing apparatus and on which the substrate to be printed is disposed. In one embodiment, the method includes performing at least a first printing operation carried out by the printing apparatus over a first print shuttle at a first position and using a first printing pressure, and at least a second printing operation carried out by the same printing apparatus over a second print shuttle at a second position and using a second printing pressure. In one embodiment, the first position is a first vertical position and the second position is a second vertical position.

In one embodiment, the first position is associated with a first distance, or height, between the printing apparatus and the substrate support surface and the second position is associated with a second distance, or height, between the printing apparatus and the substrate support surface.

In one embodiment, the method to control the printing pressure comprises performing the at least first printing operation and moving the printing apparatus over the first print shuttle to the first position to provide for the first printing pressure, and performing the at least second printing operation and moving the printing apparatus over the second print shuttle to the second position to provide for said second printing pressure.

In one embodiment, the second printing pressure matches the first printing pressure. In another embodiment, when the second printing pressure matches the first printing pressure, the second printing pressure is substantially equal to the first printing pressure.

In one embodiment, the method to control the printing pressure comprises measuring the printing pressure of at least one of the at least a first printing operation and the at least a second printing operation.

The method to control the printing pressure further comprises at least a setting operation in which, at least initially during the first printing, a first position is assigned to the apparatus for the subsequent printing, then to this first position, an optimal printing pressure exerted by the printing apparatus on the substrate is made to correspond to the value of this pressure being detected by means of pressure detection device, and a control operation, at least during the second printing, in which the printing apparatus is positioned at least initially into a position and, if a deviation in the pressure exerted by the printing apparatus on the substrate being processed is detected with respect to the previously determined optimal printing pressure, a second position is assigned to the printing apparatus for the subsequent second printing, the optimal printing pressure exerted by the printing apparatus on the substrate corresponds to the second print position.

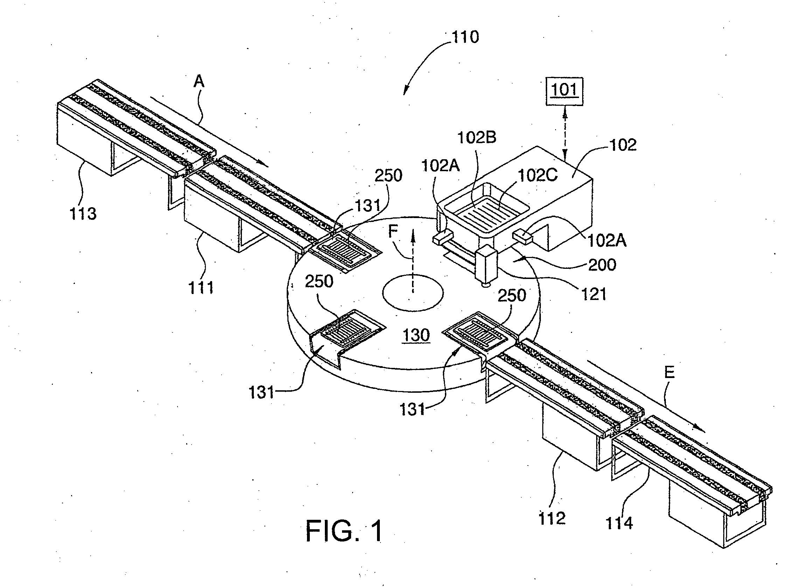

In one embodiment, it is therefore possible to provide printing conditions that are always the same in correspondence with the first and second print shuttle (e.g., printing nests 131 Figures 1-8) even without knowing precisely the exact height of the second print shuttle. Indeed, the second print shuttle can have a different height from that of the first shuttle.

Once the first and the second positions have been identified and assigned, the printing apparatus, depending on where the shuttle operates, is automatically positioned so as to satisfy the optimal pressure conditions. This overcomes the disadvantages described above with reference to the state of the art, in that, the presence of imperfections, at least in the initial and final print portions on the substrate where printing is carried out, takes into account only the printing pressure, or imperfections due to different printing pressure conditions due to the positioning of the printing apparatus always being in the same position for different print shuttles, which are used in conjunction with the printing apparatus.

In another embodiment, the printing position, in which the printing apparatus is positioned in the control operation, at least initially during the second printing, substantially corresponds to the first position determined in the setting operation. This sets a reference position for evaluating the optimal pressure. In particular, if a pressure higher than the optimal pressure is detected, this means that the printing apparatus has been positioned too low (e.g., too close to the substrate), and therefore it has to be raised with respect to the substrate surface; vice versa, if a pressure lower than the optimal pressure is detected, the printing apparatus must be positioned in a lower position with respect to the substrate surface (e.g., closer to the substrate).

In another embodiment, during the control operation, a deviation value is determined and assigned to the printing apparatus with respect to the first position, so that the printing apparatus can be moved into a desirable second position. In this way the printing apparatus, in the passage from the first to the second print shuttle, or when the first print shuttle is replaced with the second print shuttle, will be moved by the deviation value.

In yet another embodiment, a calibration operation is provided before a setting operation, in which a reciprocal distance is determined between the printing apparatus and the substrate support surface on the first print shuttle.

According to another embodiment, this reciprocal distance is estimated by correlating with each other a height of the substrate support surface and a reference height of the printing apparatus, that is, the print head with respect to a reference plane.

In another embodiment, the reference height is determined in the calibration operation, by correlating with each other a first distance measured by a measuring sensor with respect to a reference template associated with the substrate support surface, and a second distance measured by the measuring sensor with respect to the printing apparatus.

In yet another embodiment, during the first printing and after the setting operation, the printing pressure of the printing apparatus is detected and, if a deviation is detected with respect to the optimal pressure, a new updated first position is determined and assigned to the printing apparatus in order to re-establish the optimal pressure. This further control compensates for possible variations in the printing configurations, due to, for example, wear on parts of the printing apparatus, possible wear on the guides, or other variable parameters which entail a deviation with respect to the optimal printing pressure.

In another embodiment, during the second printing and after the control operation, the printing pressure of the printing apparatus is detected and, if a deviation is detected with respect to the optimal pressure, a new updated second position is determined and assigned to the printing apparatus in order to re-establish the optimal pressure.

In another embodiment, the positioning of the printing apparatus in the first position and in the second position is determined in an iterative manner, or by applying a linear filter as a function of the pressure which is detected.

Other embodiments of the inventions include a printing system which comprises a printing apparatus for printing at least a substrate and configured to integrate a method as described above.

Other embodiments provide a method to control the printing pressure on a substrate or support, which can be applied on a screen printing system, or a system 110, to form metal contacts in a desired pattern on a surface of a solar cell substrate 250.

In one embodiment, as seen in Figure 1, the screen printing system 110 comprises an incoming conveyor 111, a rotary actuator assembly 130, a screen printing chamber 102, and an outgoing conveyor 112. The incoming conveyor 111 may be configured to receive the substrate 250 from an input device, such as an input conveyor 113 (i.e., path "A"), and transfer the substrate 250 to a printing nest 131 coupled to the rotary actuator assembly 130. The outgoing conveyor 112 may be configured to receive the processed substrate 250 from the printing nest 131 coupled to the rotary actuator assembly 130 and transfer the substrate 250 to a substrate removal device, such as an exit conveyor 114 (i.e., path "E"). The input conveyor 113 and the exit conveyor 114 may be automated substrate handling devices that are part of a larger production line.

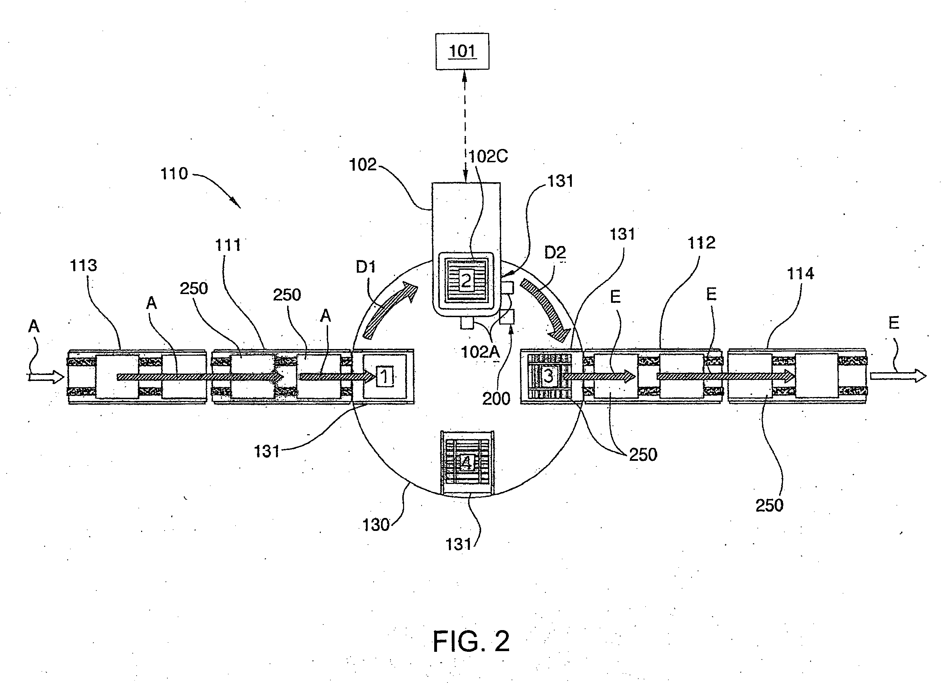

In one embodiment, the rotary actuator assembly 130 may be rotated and angularly positioned about the "F" axis by a rotary actuator (not shown) and a system controller 101, such that the printing nests 131 may be selectively angularly positioned within the screen printing system 110 (e.g., paths "D1" and "D2" as seen in Figure 2). The rotary actuator assembly 130 may also have one or more supporting components to facilitate the control of the printing nests 131 or other automated devices used to perform a substrate processing sequence in the screen printing system 110.

In one embodiment, as seen in Figure 1, the rotary actuator assembly 130 includes four printing nests 131, or substrate supports, that are each adapted to support substrate 250 during the screen printing process performed within the screen printing chamber 102. Figure 2 schematically illustrates the position of the rotary actuator assembly 130 in which: (i) one printing nest 131 is configured in position "1" to receive substrate 250 from the incoming conveyor 111; (ii) another printing nest 131 is configured in position "2" within the screen printing chamber 102 so that another substrate 250 can receive a screen printed pattern on a surface thereof; (iii) another printing nest 131 is configured in position "3" for transferring a processed substrate 250 to the outgoing conveyor 112; and (iv) another printing nest 131 is configure in position "4", which is an intermediate stage between position "1" and position "3."

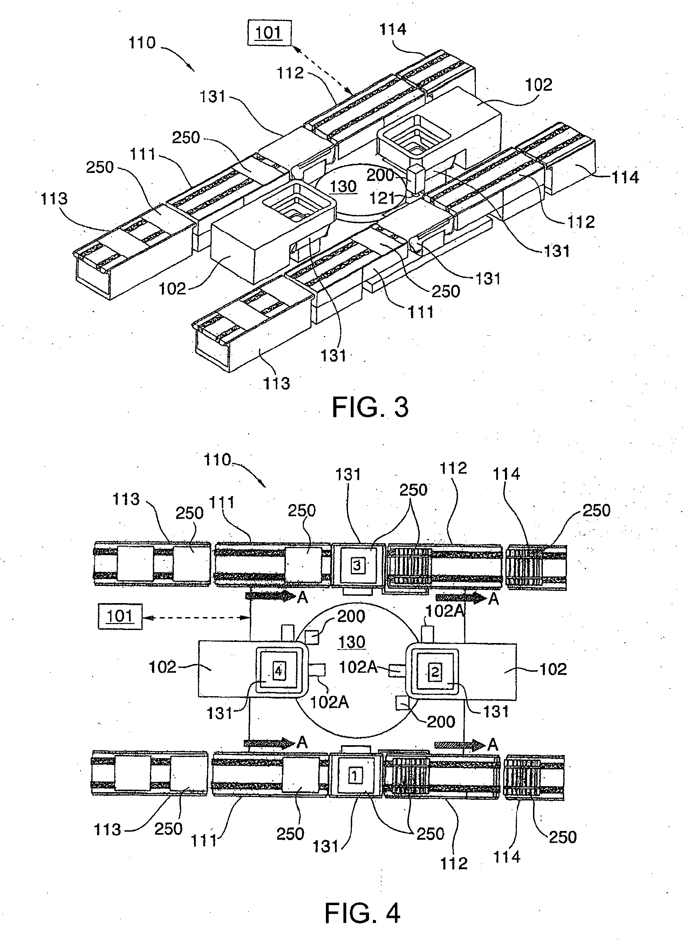

Figure 3 is an isometric view of another embodiment of screen printing system 110, and Figure 4 is a top plan view of the screen printing system 110 of Figure 3, that can also be used in conjunction with other forms of embodiment to form the metal contacts in a desired pattern on the surface of the solar cell substrate 250.

In one embodiment, the screen printing system 110 disclosed in Figures 3 and 4 comprises two incoming conveyors 111 and the actuator assembly 130 is configured as a rotary table or rotary actuator. The screen printing system 110 also includes a plurality of printing nests 131, a plurality of screen print chambers 102, two outgoing conveyors 112, and the system controller 101. The incoming conveyors 111 are configured in a parallel processing orientation so that each can receive unprocessed substrates 250 from an input device, such as input conveyor 113, and transfer each unprocessed substrate 250 to printing nest 131 coupled to the actuator assembly 130. In addition, the outgoing conveyors 112 are configured in a parallel orientation so that each outgoing conveyor 112 can receive a processed substrate 250 from the printing nest 131 and transfer each processed substrate 250 to a substrate removal device, such as the exit conveyor 114.

In one embodiment, the screen printing system 110 in Figures 3 and 4 has two printing nests 131 (in positions "1" and "3"), each positioned to both transfer a processed substrate 250 to the outgoing conveyor 112 and also to receive a non-processed substrate 250 from the incoming conveyor 111.

Thus, in the screen printing system 110 in Figures 3 and 4, the movement of the substrate generally follows the path "A." In this configuration, each of the two other printing nests 131 (in positions "2" and "4") is positioned under the screen printing chamber 102, so that screen printing can be carried out on the non-processed substrates 250 located on the respective printing nests 131.

This parallel processing configuration allows for an increased productive capacity with minimum bulk in the processing system. Although the screen printing system 110 illustrated in Figures 3 and 4 is with two screen printing chambers 102 and four printing nests 131, the screen printing system 110 can include additional screen printing chambers 102 and/or printing nests 131, without departing from the field of the present invention.

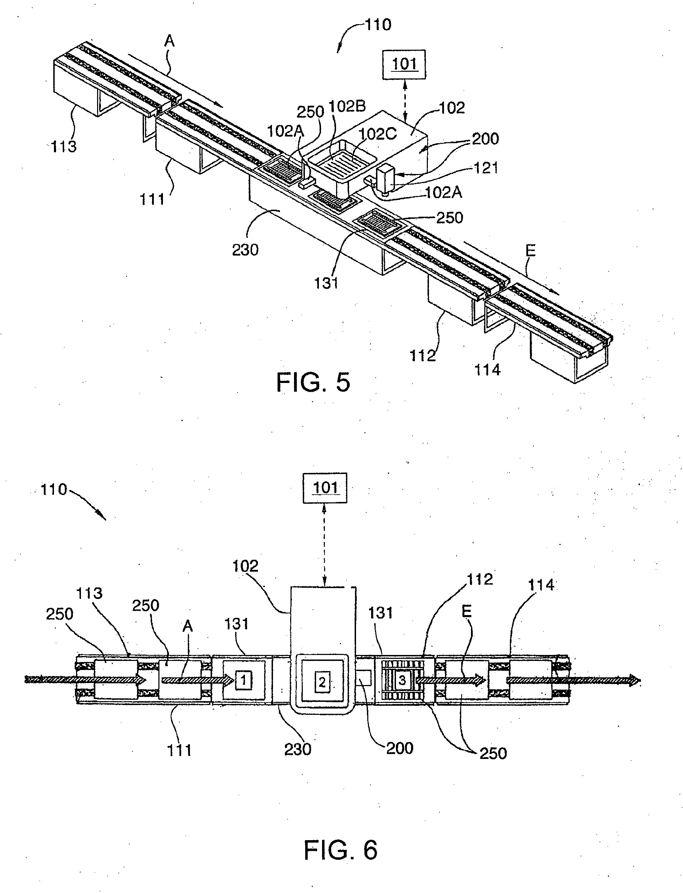

Figure 5 is an isometric view of another embodiment of a screen printing system 110, and Figure 6 is a top plan view of the screen printing system 110, which can be used also in conjunction with other forms of embodiment to form the metal contacts in a desired pattern on the surface of the solar cell substrate 250.

In one embodiment, the screen printing system 110 disclosed in Figures 5 and 6 comprises incoming conveyor 111, an actuator assembly 230, which is configured as a linear movement unit, screen printing chamber 102, outgoing conveyor 112 and system controller 101. The incoming conveyor 111 can be configured to receive substrate 250 from an input device, such as input conveyor 113 (i.e., path "A" in Figures 5 and 6), and transfer the substrate 250 to the printing nest 131 coupled at an inlet of the actuator assembly 230. The outgoing conveyor 112 can be configured to receive a processed substrate 250 from the printing nest 131 coupled at an exit of the actuator assembly 230 and transfer the substrate 250 to a substrate removal device, such as exit conveyor 114 (i.e., path "E" in Figures 5 and 6). As mentioned above, the input conveyor 113 and the exit conveyor 114 may be automated substrate handling devices that are part of a larger production line.

The incoming conveyor 111 transports the substrate 250 from: (i) a first position "1," as seen in Figure 6, in which substrate 250 is introduced into the screen printing chamber 102; (ii) a second position "2" inside the screen printing chamber 102; and (iii) a third position "3" in which the processed substrate 250 is discharged from the screen printing chamber 102 and conveyed to other operating stations. In the case of a double or multiple printing, the substrate 250 is again introduced into the screen printing chamber 102 in position "2" to carry out a second or further printing and is then discharged again from the screen printing chamber 102 passing to position "3." This alternate movement is repeated a desired number of times to coordinate with the number of layers to be printed, until the final product is definitively discharged.

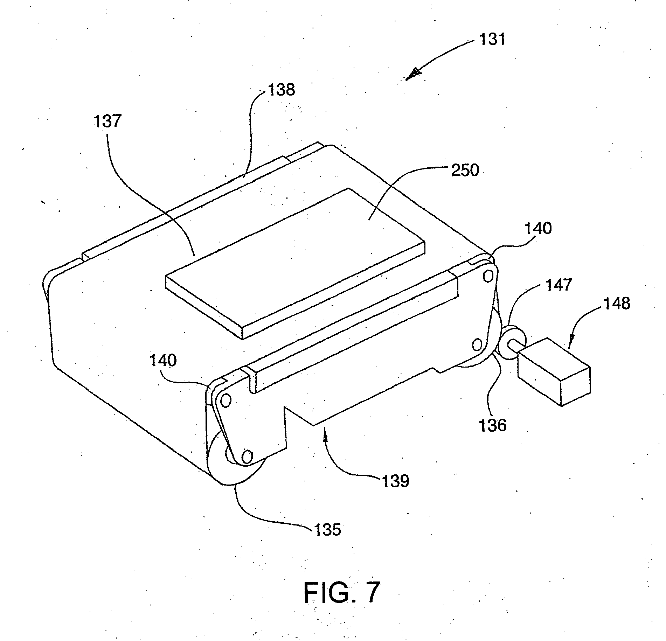

Referring to Figure 7, printing nest 131 generally consists of a conveyor assembly 139 that has a feed spool 135, a take-up spool 136, rollers 140 and one or more actuators 148, which are coupled to the feed spool 135 and/or take-up spool 136, that are adapted to feed and retain a supporting material 137 positioned across a platen 138. The platen 138 generally has a substrate supporting surface on which the substrate 250 and supporting material 137 are positioned during the screen printing process performed in the screen printing chamber 102. In one embodiment, the supporting material 137 is a porous material that allows substrate 250, which is disposed on one side of the supporting material 137, to be retained on the platen 138 by a vacuum applied to the opposing side of the supporting material 137 by a conventional vacuum generating device (*e.g.*, vacuum pump, vacuum ejector). In one embodiment, a vacuum is applied to vacuum ports (not shown) formed in the substrate supporting surface of the platen 138 so that the substrate can be "chucked" to the substrate supporting surface of the platen 138. In one embodiment, the supporting material 137 is a transpirable material that consists, for instance, of a transpirable paper of the type used for cigarettes or another analogous material, such as a plastic or textile material that performs the same function.

In one configuration, the actuators 148 are coupled to, or are adapted to engage with, the feed spool 135 and the take-up spool 136 so that the movement of substrate 250 positioned on the supporting material 137 can be accurately controlled within the printing nest 131. In one embodiment, feed spool 135 and take-up spool 136 are each adapted to receive opposing ends of a length of the supporting material 137. In one embodiment, the actuators 148 each contain one or more drive wheels 147 that are coupled to, or in contact with, the surface of the supporting material 137 positioned on the feed spool 135 and/or the take-up spool 136 to control the motion and position of the supporting material 137 across the platen 138.

Referring to Figures 1-6, each of the screen printing chambers 102 described in the screen printing systems 110 is adapted to deposit material in a desired pattern on the surface of substrate 250, which is positioned on printing nest 131 in position "2" during the screen printing process. In one embodiment, the screen printing chamber 102 includes a plurality of actuators, for example, actuators 102A (e.g., stepper motors or servomotors) that are in communication with the system controller 101 and are used to adjust the position and/or angular orientation of a screen printing mask 102B, as seen in Figures 1 and 5, disposed within the screen printing chamber 102 with respect to the substrate 250 being printed. In one embodiment, the screen printing mask 102B is a metal sheet or plate (e.g., SST) with a plurality of distinctive features 102C, as seen in Figures 1 and 5, such as holes, slots, or other apertures formed therethrough to define a pattern and placement of screen printed material (i.e., ink or paste) on the surface of a substrate 250. In general, the screen printed pattern that is to be deposited on the surface of a substrate 250 is aligned to the substrate 250 in an automated fashion by orienting the screen printing mask 102B in a desired position over the substrate surface using the actuators 102A and information received by the system controller 101 from an inspection assembly 200. In one embodiment, the screen printing chamber 102 is adapted to deposit a metal containing or dielectric containing material on a solar cell substrate 250 having a width between about 125 mm and 156 mm and a length between about 70 mm and about 156 mm. In one embodiment, the screen printing chamber 102 is adapted to deposit a metal containing paste on the surface of the substrate 250 to form the metal contact structure on a surface of a substrate.

Inspection assembly 200 is associated with each of the screen printing systems 110 shown in Figures 1-6 and is adapted to inspect substrate 250 disposed on the printing nest 131 on which the desired pattern is printed by means of screen printing.

The inspection assembly 200 is adapted to identify and inspect the substrates 250 before and after printing and may comprise one or more cameras 121 (e.g., CCD camera), as seen in Figures 1, 3, and 5, and other electronic components capable of inspecting and communicating the inspection results to the system controller 101 used to analyze the orientation and position of the substrate 250 on the printing nest 131.

In one embodiment, the camera 121, seen in Figures 1 and 3, is positioned over the surface of the substrate 250 so that the camera 121 can inspect at least one region of the surface of the substrate 250. The information received by the camera 121 is used both to align the screen printing mask 102B and thus the subsequently deposited material, and also to acquire an image of the layer deposited on the substrate 250.

In one embodiment, the camera 121 is an InGaAs type camera that has a cooled CCD array to enhance the signal-to-noise ratio of the detect signal. In some configurations, it is desirable to isolate the inspection assembly 200 from ambient light by enclosing or shielding the areas between the surface of the substrate 250 and the camera 121.

In one embodiment, the inspection assembly 200 also includes one or more optical filters (not shown) that are disposed between the camera 121 and the surface of the substrate 250. In this embodiment, the optical filter(s) is/are selected to allow only certain desired wavelengths to pass to the camera 121 to reduce the amount of unwanted energy being received by the camera 121 to improve the signal-to-noise ratio of the detected radiation. The optical filter(s) can be a bandpass filter, a narrowband filter, an optical edge filter, a notch filter, or a wideband filter purchased from, for example, Barr Associates, Inc. or from Andover Corporation.

The system controller 101 facilitates the control and automation of the overall screen printing system 110 and may include a central processing unit (CPU) (not shown), memory (not shown), and support circuits (or I/O) (not shown). The CPU may be one of any form of computer processors that are used in industrial settings for controlling various chamber processes and hardware (*e.g.*, conveyors, optical inspection assemblies, motors, fluid delivery hardware, etc.) and monitor the system and chamber processes (*e.g.*, substrate position, process time, detector signal, etc.). The memory is connected to the CPU, and may be one or more of a readily available memory, such as random access memory (RAM), read only memory (ROM), floppy disk, hard disk, or any other form of digital storage, local or remote. Software instructions and data can be coded and stored within the memory for instructing the CPU. The support circuits are also connected to the CPU for supporting the processor in a conventional manner. The support circuits may include cache, power supplies, clock circuits, input/output circuitry, subsystems, and the like. A program (or computer instructions) readable by the system controller 101 determines which tasks are performable on a substrate. Preferably, the program is software readable by the system controller 101, which includes code to generate and store at least substrate positional information, the sequence of movement of the various controlled components, substrate optical inspection system information, and any other corresponding combination.

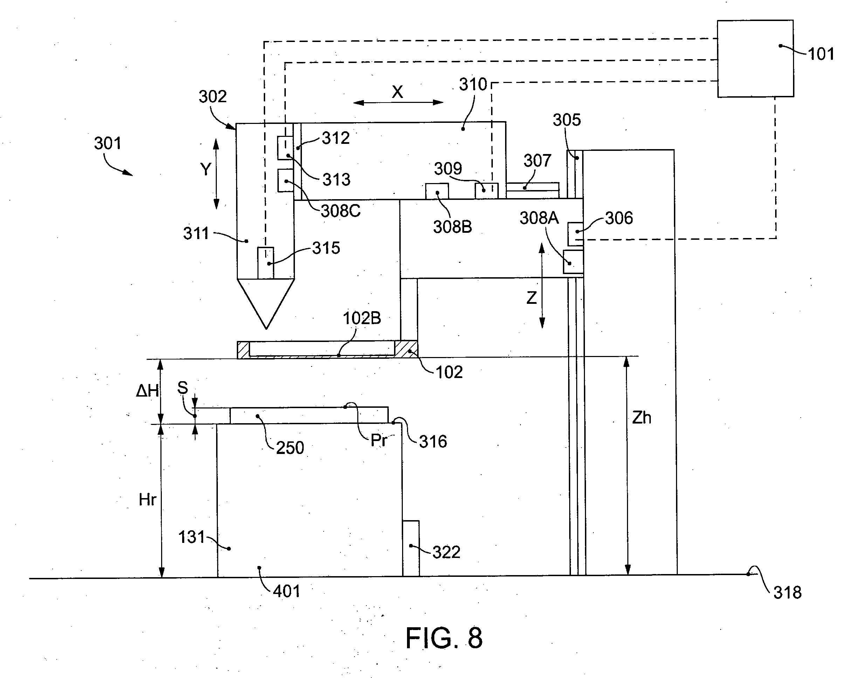

Figure 8 shows a schematic view of a printing apparatus 301 used to perform a printing operation on a substrate 250 that is positioned on, or in some correspondence with, a shuttle 401. The shuttle 401 comprises one of the printing nests 131 (Figures 1-8) and can be integrated into the rotary actuator assembly 130 or into the actuator assembly 230 described with reference to Figures 1-4 and respectively to Figures 5 and 6.

In operation, the shuttle 401 is disposed within the screen printing chamber 102 to perform the printing operations. In one embodiment, a printing apparatus 301 includes the screen printing chamber 102, which is selectively moved relative to the shuttle 401 in a first direction Z, in this case a vertical direction, and a print head 302 associated with the screen printing chamber 102. More specifically, the screen printing chamber 102 is selectively movable along first guides 305 parallel to the first direction Z using a print chamber motor 308A, and a first position detector, for example a first encoder 306, detects the relative position of the screen printing chamber 102.

The print head 302 is selectively movable with respect to the screen printing chamber 102 in a second direction X, transverse to the first direction Z, in this case a horizontal direction by use of one or more print head motors, in Figure 8 a print head motor 308B. The print head 302 is therefore movable both in the first direction Z, along with the screen printing chamber 102, and also in the second direction X, independent from the screen printing chamber 102 and along second guides 307.

In one embodiment, a second position detector, for example a second encoder 309, detects the relative position of the print head 302 with respect to the screen printing chamber 102. The print head 302 includes a support body 310 that can be moved along the second guides 307 by use of the print head motor 308B, and a blade 311 that is used to distribute the printing material uniformly on the screen printing mask 102B. The blade 311 is selectively movable with respect to the support body 310 along guides 312 and in a third direction Y which is substantially parallel to the first direction Z by use of the one or more blade motors, in Figure 8 a blade motor 308C.

In one embodiment, a third position detector, for example a third encoder 313, determines the position of the blade 311 with respect to the support body 310.

In one embodiment, pressure detection means, for example a pressure detector 315, are associated with the blade 311 and detect the value of the pressure with which the blade 311 is pressed against the printing mask 102B. The pressure detection means can carry out a direct or an indirect detection. In one embodiment, the pressure is detected by detecting the intensity of the current driving a motor of the blade 311, which moves the blade 311 towards the printing mask 102B to press the blade 311 against the substrate 250. The intensity of the current driving the blade motor 308C of the blade 311 is correlated to the value of the pressure exerted by the blade 311 on the substrate 250. In one configuration, the position of the blade 311 that interacts with the printing mask 102B could be a function of the blade material. In one embodiment, the blade material comprises a polymeric material selected at least between a polyurethane and a silicone material.

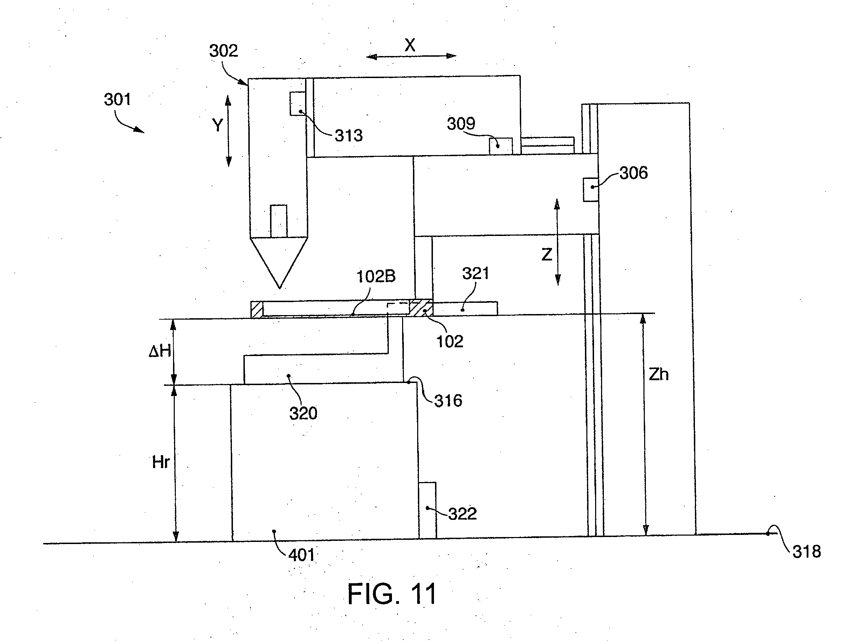

In one embodiment, a method for controlling a printing pressure on a substrate comprises at least a calibration operation to determine a position of the screen printing chamber 102 with respect to the shuttle 401 which is considered a reference shuttle. The calibration operation uses a template 320, as seen in Figure 11, which, in the setting operation of the printing apparatus 301, is positioned on a substrate support surface 316 of the reference shuttle 401. The template 320 has a portion 321 protruding with respect to the substrate support surface 316 and the bulk of the reference shuttle 401. A measuring sensor 322, for example a laser or any other suitable measuring sensor, is disposed in a fixed position, for example attached to a reference plane 318, and is adapted to measure the distance between the reference plane 318 and the protruding portion 321 of the template 320. The distance between the reference plane 318 and the protruding portion 321 of the template 320 has a substantially known value, based on the sizes of the template 320 and the sizes of the reference shuttle 401. Subsequently, the screen printing chamber 102 is moved in the first direction Z so as to position a lower surface of the print mask 102B at the same distance from the reference plane 318 as previously detected with the template 320, so as to associate it with a reference position.

It is therefore possible to associate the screen printing chamber 102 with a reference height Zh, for example with respect to the reference plane 318, which is common both to the printing apparatus 301 and the reference shuttle 401. The height of the reference shuttle 401 is known, by knowing the distance Hr of the substrate support surface 316 with respect to the reference plane 318.

Due to the detection of at least the heights Zh and Hr, as seen in Figure 8, it is possible to determine the distance ΔH between the lower surface of the print mask 102B and the substrate support surface 316 of the reference shuttle 401. One skilled in the art would understand that the reference height Zh, associated with the screen printing chamber 102, can be determined in other ways.

The other movements of the print chamber 102 along the first guides 305 are evaluated according to the data detected by the first 306 and second encoder 309 and the signals detected by the second encoder 309 are sent to the controller 101.

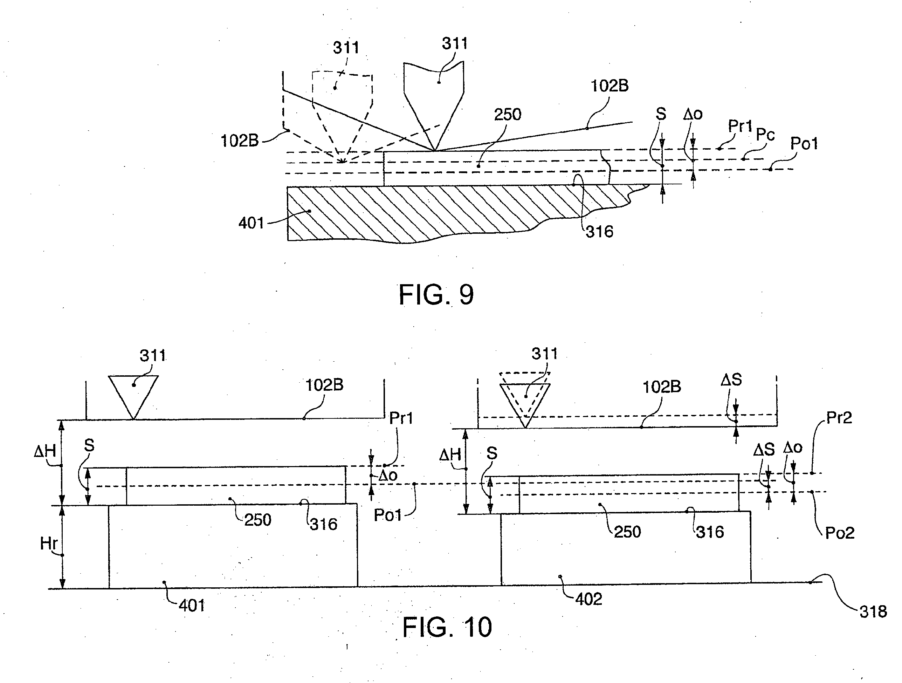

During the printing, with the known value of the thickness S of the substrate 250 and the height Hr of the reference shuttle 401, it is possible to determine a first print position Pr1 (Figure 9) where the blade 311 and the print chamber 102 will operate. The thickness S of the substrates 250 may be considered substantially constant for the different substrates that are used, except for production tolerances which may be considered negligible, or variations in size due to a variation in the production batch of the substrate 250.

The first print position Pr1 (Figure 9) corresponds to the actual height where the print surface of the substrate 250 is disposed with respect to the reference plane 318.

After the calibration operation, embodiments of the method to control the printing pressure on a substrate provide a setting operation in which a plurality of prints are made on different substrates 250 in order to evaluate, for example by means of optical inspection with the cameras 121, that the printing has been carried out correctly.

More specifically, during these printing operations, it is provided that the blade 311 exerts a determinate pressure, for example about 80N, on the print surface of the substrate 250. This pressure guarantees that there is contact between the blade 311 and the print mask 102B and allows the paste to be deposited correctly on the substrate 250 through meshes of the print mask 102B.

Following repeated printing operations a first print position Po1, as seen in Figure 10, is determined to be assigned to the blade 311 so as to guarantee printing with desired quality and repeatability. An optimal printing pressure corresponds to the first print position Po1.

So that the blade 311 exerts the optimal pressure on the substrate 250, the first print position Po1 is disposed below the deposition surface of the substrate 250 and, in some configurations, advantageously in an intermediate position between the thickness S of the substrate 250. That is, the first print position Po1 is located under the first actual print position Pr1 of the blade 311, at an optimal distance Δo, which for example can be around 100µm.

During the printing operations carried out in the reference shuttle 401, the blade 311 corresponds with the first print position Po1, shown in Figure 9 by dashed lines, and is subsequently translated horizontally, grazing the surface of the print mask 102B to deposit the conductive material, and positioning itself in correspondence with the first actual print position Pr1.

During the printing operations carried out in the reference shuttle 401, a control operation is provided in which the pressure detector 315 detects the pressure the blade 311 exerts on the substrate 250 and, if a deviation is detected with respect to the optimal pressure determined in the setting operation, a movement is carried out on the blade 311 to re-establish a correct condition.

The possible deviation that is determined may be due to, for example, wear on parts of the blade, a different average height of the substrates, or other parameters. The variation in movement of the blade 311 is determined iteratively by commanding its positioning in subsequent commanded positions Pc, as shown by the dashed lines in Figure 9, until the first print position Po1 is reached, to which the optimal printing pressure corresponds.

In order to ensure that an optimal printing condition is rapidly restored, in relation to the positional data of at least the first encoder 306 and third encoder 313 and the pressure data detected by the pressure detector 315, or by means of an indirect detection as described above, the controller 101 determines, for example by means of a linear filter operation, the commanded positions Pc to be assigned to the blade 311 in order to return the commanded positions Pc to substantially coincide with the first position Po1. The linear filter operation correlates the position assumed by the apparatus 301 with at least the actual pressure exerted by the blade 311 on the substrate 250.

The printing apparatus 301 carries out the printing operations also in correspondence with other print shuttles, for example in correspondence to a second shuttle 402, as seen in Figure 10, whose height Hr with respect to the reference plane 318 is not known.

The height of the second shuttle 402 may be different from that of the reference shuttle 401, and therefore, it is necessary to determine a deviation ΔS, or the difference between the first position Po1 of the reference shuttle 401 and the desired second position Po2 of the second shuttle 402, to be assigned to the blade 311 in order to establish optimal printing conditions for the second shuttle 402.

When the second shuttle 402 corresponds with the printing apparatus 301, the blade 311 finds itself operating substantially in the same commanded position Pc as previously determined in the reference shuttle 401. Because of the different heights of the reference shuttle 401 and the second shuttle 402, the blade 311 has to be positioned in a second actual print position Pr2 when it is operating in the second shuttle 402, which is different from the first actual print position Pr1 in which it operates in the reference shuttle 401. This causes a different printing process condition when using the second shuttle 402, which does not correspond with the optimal conditions defined previously in the setting step.

In order to re-establish optimal printing conditions when the printing is started in correspondence with the second shuttle 402, the method starts to detect the pressure exerted by the blade 311 on the substrate 250 by means of direct or indirect measurement. If a deviation is found with respect to the optimal pressure previously set in the setting operation, the controller 101 will control the pressure exerted by the blade 311 to establish an optimal functioning condition in the second shuttle 402 as well.

Therefore a restoration operation is started, in which the controller 101 determines the deviation ΔS to be assigned to the printing apparatus 301 by moving the printing apparatus 301 along the first guides 305 in the first direction Z in order to re-establish an optimal printing pressure in the second shuttle 402.

The restoration operation positions the blade 311 in a plurality of commanded positions Pc until a second print position Po2 assigned to the second shuttle 402 is reached. During the subsequent printing operations, which are carried out in correspondence with the second shuttle 402 and follow printing operations performed on other shuttles, the controller 101 commands the print blade 311 to be positioned directly in correspondence with the second print position Po2 in the second shuttle 402.

During the printing operations which are carried out after the second position Po2 has been determined, the pressure exerted by the blade 311 on the substrate 250 is controlled and, if a deviation is found, operations to restore the optimal printing conditions as previously determined are started.

Such deviations may be due to wear on parts of the blade 311, a variation in the average height of the substrates 250, possible play between the guides and the mobile parts of the printing apparatus 301, or other factors.

The detection of wear on parts of the blade 311, or variation in the average height of the substrates 250, is carried out in the reference shuttle 401. If a deviation is found with respect to the optimal printing pressure, the blade 311 is simply repositioned with respect to the whole printing apparatus 301, by moving it along the sliding guides 312.

The above embodiments may be applied to not only two shuttles, but also to three, four or more shuttles (e.g., printing nest 131) which can be used with the printing apparatus 301. In one embodiment, an initial operation of starting the printing system includes a calibration step in correspondence with a shuttle considered as a reference shuttle to determine optimal printing conditions, and the subsequent steps of the control method are applied in the same way, as described above, on each of the other shuttles whose heights are unknown. The controller 101 therefore determines an optimal print position to be assigned for each shuttle. That is, the deviation ΔS to be assigned to the blade 311 when it is operating, with one or another of the shuttles.

While the foregoing is directed to embodiments of the present invention, other and further embodiments of the invention may be devised without departing from the basic scope thereof, and the scope thereof is determined by the claims that follow.

## Claims

1. A method to control a printing pressure on a solar cell substrate (250) for producing a solar cell, comprising:
performing at least a first printing operation on a first solar cell substrate with a printing apparatus that is disposed relative to a first print shuttle (131), which has a substrate supporting surface (137) that is disposed at a first position, wherein the first printing operation is performed at a first printing pressure; and
performing at least a second printing operation on a second solar cell substrate disposed on a substrate supporting surface of a second print shuttle using the printing apparatus, wherein the second printing operation is performed when the substrate supporting surface of the second print shuttle is disposed at a second position, and is performed at a second printing pressure,
wherein if a deviation is detected between the second printing pressure and the first printing pressure, the position of the printing apparatus relative to the second position is changed to match the second printing pressure to the first printing pressure.

2. The method of claim 1, wherein the position of the printing apparatus relative to the second position is changed in a vertical direction (z).

3. The method of claim 1, 2 or 3, wherein performing the at least first printing operation comprises positioning the printing apparatus in the first printing position over the first print shuttle, and wherein performing the at least second printing operation comprises positioning the printing apparatus in the second printing position over the second print shuttle.

4. The method of any of the preceding claims, wherein the second printing pressure matches the first printing pressure.

5. The method of any of the preceding claims, further comprising:
measuring a printing pressure of the at least first printing operation and the at least second printing operation.

6. The method of any of the preceding claims, wherein a deviation between the second position with respect to the first position is used to move the printing apparatus into the second position.

7. The method of any of the preceding claims, further comprising:
performing a calibration operation wherein a distance between the printing apparatus and the substrate support surface on the first print shuttle is estimated.

8. The method of claim 7, wherein the distance is estimated by correlating a height of the substrate support surface and a reference height of the printing apparatus with respect to a reference plane.

9. The method of claim 8, wherein the reference height of the printing apparatus is determined by correlating a distance between the printing apparatus and the reference plane.

10. The method of any of the preceding claims, further comprising:
measuring a third printing pressure of the at least a first printing operation and changing the first position of the at least a first printing operation to match the third printing pressure to the first printing pressure.

11. The method of any of the preceding claims, further comprising:
measuring a fourth printing pressure of the at least a second printing operation and changing the second position of the at least a second printing operation to match the second printing pressure to the first printing pressure.

12. The method of any of the preceding claims, wherein changing the first and second position is performed iteratively, or performed by applying a linear filter operation as a function of the printing pressures detected.

13. A printing system for producing solar cells (250), comprising:
a first print shuttle (131) that has a substrate supporting surface (137) that is disposed at a first position;
a second print shuttle (131) that has a substrate supporting surface that is disposed at a second position;
one or more position detectors (306, 353) configured to detect a position of a printing apparatus with respect to the substrate supporting surface of the first print shuttle; and
a controller (101) configured to control:
a first printing operation using the printing apparatus when it is disposed relative to the substrate supporting surface of the first print shuttle, wherein the first printing operation is performed at a first printing pressure, and
a second printing operation using the printing apparatus when it is disposed relative to the substrate supporting surface of the second print shuttle, wherein the second printing operation is performed at a second printing pressure,
wherein the controller is further configured to detect a deviation between the second printing pressure and the first printing pressure, and to change the position of the printing apparatus relative to the second position to match the second printing pressure to the first printing pressure.

14. The printing system of claim 13, wherein the controller is configured to change the position of the printing apparatus relative to the second position in a vertical direction.

15. The printing system of claim 13 or 14, further comprising:
one or more pressure detectors configured to detect the pressure exerted by the printing apparatus during the first printing operation and the second printing operation.

## Patentansprüche

1. Verfahren zum Steuern einer Druckkraft auf ein Solarzellensubstrat (250) zum Herstellen einer Solarzelle, umfassend:
Durchführen wenigstens eines ersten Druckvorgangs auf ein erstes Solarzellensubstrat mit einer Druckvorrichtung, die relativ zu einem ersten Druckshuttle (131), das eine an einer ersten Position angeordnete Substratträgerfläche (137) aufweist, angeordnet ist, wobei der erste Druckvorgang mit einer ersten Druckkraft durchgeführt wird; und
Durchführen wenigstens eines zweiten Druckvorgangs auf ein zweites Solarzellensubstrat, das auf einer Substratträgerfläche eines zweiten Druckshuttles angeordnet ist, unter Verwendung der Druckvorrichtung, wobei der zweite Druckvorgang durchgeführt wird, wenn die Substratträgerfläche des zweiten Druckshuttles an einer zweiten Position angeordnet ist, und mit einer zweiten Druckkraft durchgeführt wird,
wobei, wenn eine Abweichung zwischen der zweiten Druckkraft und der ersten Druckkraft erfasst wird, die Position der Druckvorrichtung relativ zur zweiten Position verändert wird, um die zweite Druckkraft an die erste Druckkraft anzupassen.

2. Das Verfahren nach Anspruch 1, wobei die Position der Druckvorrichtung relativ zur zweiten Position in einer vertikalen Richtung (z) verändert wird.

3. Das Verfahren nach Anspruch 1 oder 2, wobei das Durchführen des wenigstens einen ersten Druckvorgangs ein Positionieren der Druckvorrichtung in der ersten Druckposition über dem ersten Druckshuttle umfasst, und wobei das Durchführen des wenigstens einen zweiten Druckvorgangs ein Positionieren der Druckvorrichtung in der zweiten Druckposition über dem zweiten Druckshuttle umfasst.

4. Das Verfahren nach einem der vorstehenden Ansprüche, wobei die zweite Druckkraft an die erste Druckkraft angepasst ist.

5. Das Verfahren nach einem der vorstehenden Ansprüche, weiter umfassend:
Messen einer Druckkraft des wenigstens eines ersten Druckvorgangs und des wenigstens einen zweiten Druckvorgangs.

6. Das Verfahren nach einem der vorstehenden Ansprüche, wobei eine Abweichung zwischen der zweiten Position bezüglich der ersten Position verwendet wird, um die Druckvorrichtung in die zweite Position zu bewegen.

7. Das Verfahren nach einem der vorstehenden Ansprüche, weiter umfassend:
Durchführen eines Kalibriervorgangs, wobei ein Abstand zwischen der Druckvorrichtung und der Substratträgerfläche auf dem ersten Druckshuttle geschätzt wird.

8. Das Verfahren nach Anspruch 7, wobei der Abstand geschätzt wird, indem eine Höhe der Substratträgerfläche und eine Referenzhöhe der Druckvorrichtung bezüglich einer Referenzebene korreliert werden.

9. Das Verfahren nach Anspruch 8, wobei die Referenzhöhe der Druckvorrichtung durch ein Korrelieren eines Abstands zwischen der Druckvorrichtung und der Referenzebene bestimmt wird.

10. Das Verfahren nach einem der vorstehenden Ansprüche, weiter umfassend:
Messen einer dritten Druckkraft des wenigstens einen ersten Druckvorgangs und Verändern der ersten Position des wenigstens einen ersten Druckvorgangs, um die dritte Druckkraft an die erste Druckkraft anzupassen.

11. Das Verfahren nach einem der vorstehenden Ansprüche, weiter umfassend:
Messen einer vierten Druckkraft des wenigstens einen zweiten Druckvorgangs und Verändern der zweiten Position des wenigstens einen zweiten Druckvorgangs, um die zweite Druckkraft an die erste Druckkraft anzupassen.

12. Das Verfahren nach einem der vorstehenden Ansprüche, wobei das Verändern der ersten und der zweiten Position iterativ oder durch Anwenden eines linearen Filtervorgangs als Funktion der erfassten Druckkräfte durchgeführt wird.

13. Drucksystem zum Herstellen von Solarzellen (250), umfassend:
ein erstes Druckshuttle (131), das eine Substratträgerfläche (137) aufweist, die an einer ersten Position angeordnet ist;
ein zweites Druckshuttle (131), das eine Substratträgerfläche (137) aufweist, die an einer zweiten Position angeordnet ist;
einen oder mehrere Positionsdetektoren (306, 353), die eingerichtet sind, um eine Position einer Druckvorrichtung bezüglich der Substratträgerfläche des ersten Druckshuttles zu erfassen; und
eine Steuerung, die eingerichtet ist, um das Folgende zu steuern:
einen ersten Druckvorgang unter Verwendung der Druckvorrichtung, wenn sie relativ zur Substratträgerfläche des ersten Druckshuttles angeordnet ist, wobei der erste Druckvorgang mit einer ersten Druckkraft durchgeführt wird, und
einen zweiten Druckvorgang unter Verwendung der Druckvorrichtung, wenn sie relativ zur Substratträgerfläche des zweiten Druckshuttles angeordnet ist, wobei der zweite Druckvorgang mit einer zweiten Druckkraft durchgeführt wird,
wobei die Steuerung weiter eingerichtet ist, um eine Abweichung zwischen der zweiten Druckkraft und der ersten Druckkraft zu erfassen, und um die Position der Druckvorrichtung relativ zur zweiten Position zu verändern, um die zweite Druckkraft an die erste Druckkraft anzupassen.

14. Das Drucksystem nach Anspruch 13, wobei die Steuerung eingerichtet ist, um die Position der Druckvorrichtung relativ zur zweiten Position in einer vertikalen Richtung zu verändern.

15. Das Drucksystem nach Anspruch 13 oder 14, weiter umfassend:
einen oder mehrere Druckdetektoren, die eingerichtet sind, um den durch die Druckvorrichtung während des ersten Druckvorgangs und des zweiten Druckvorgangs ausgeübten Druck zu erfassen.

## Revendications

1. Procédé de commande d'une pression d'impression sur un substrat de cellule solaire (250) servant à produire une cellule solaire, comprenant :
l'exécution d'au moins une première opération d'impression sur un premier substrat de cellule solaire avec un dispositif d'impression qui est disposé relativement à une première navette d'impression (131) qui présente une surface de support de substrat (137) qui est disposée à une première position, sachant que la première opération d'impression est exécutée à une première pression d'impression ; et
l'exécution d'au moins une deuxième opération d'impression sur un deuxième substrat de cellule solaire disposé sur une surface de support de substrat d'une deuxième navette d'impression moyennant le dispositif d'impression, sachant que la deuxième opération d'impression est exécutée lorsque la surface de support de substrat de la deuxième navette d'impression est disposée à une deuxième position, et est exécutée à une deuxième pression d'impression,
sachant que si un écart est détecté entre la deuxième pression d'impression et la première pression d'impression, la position du dispositif d'impression relativement à la deuxième position est modifiée afin de faire correspondre la deuxième pression d'impression à la première pression d'impression.

2. Le procédé de la revendication 1, dans lequel la position du dispositif d'impression relativement à la deuxième position est modifiée dans une direction verticale (z).

3. Le procédé de la revendication 1, 2 ou 3, dans lequel l'exécution de l'au moins une première opération d'impression comprend le fait de positionner le dispositif d'impression dans la première position d'impression au-dessus de la première navette d'impression, et dans lequel l'exécution de l'au moins une deuxième opération d'impression comprend le fait de positionner le dispositif d'impression dans la deuxième position d'impression au-dessus de la deuxième navette d'impression.

4. Le procédé de l'une quelconque des revendications précédentes, dans lequel la deuxième pression d'impression correspond à la première pression d'impression.

5. Le procédé de l'une quelconque des revendications précédentes, comprenant en outre :
la mesure d'une pression d'impression de l'au moins une première opération d'impression et de l'au moins une deuxième opération d'impression.

6. Le procédé de l'une quelconque des revendications précédentes, dans lequel un écart entre la deuxième position par rapport à la première position est utilisé pour amener le dispositif d'impression dans la deuxième position.

7. Le procédé de l'une quelconque des revendications précédentes, comprenant en outre :
l'exécution d'une opération de calibrage dans laquelle une distance entre le dispositif d'impression et la surface de support de substrat sur la première navette d'impression est estimée.

8. Le procédé de la revendication 7, dans lequel la distance est estimée par mise en corrélation d'une hauteur de la surface de support de substrat et d'une hauteur de référence du dispositif d'impression par rapport à un plan de référence.

9. Le procédé de la revendication 8, dans lequel la hauteur de référence du dispositif d'impression est déterminée par mise en corrélation d'une distance entre le dispositif d'impression et le plan de référence.

10. Le procédé de l'une quelconque des revendications précédentes, comprenant en outre :
la mesure d'une troisième pression d'impression de l'au moins une première opération d'impression et le changement de la première position de l'au moins une première opération d'impression pour faire correspondre la troisième pression d'impression à la première pression d'impression.

11. Le procédé de l'une quelconque des revendications précédentes, comprenant en outre :
la mesure d'une quatrième pression d'impression de l'au moins une deuxième opération d'impression et le changement de la deuxième position de l'au moins une deuxième opération d'impression pour faire correspondre la deuxième pression d'impression à la première pression d'impression.

12. Le procédé de l'une quelconque des revendications précédentes, dans lequel le changement de la première et de la deuxième position est exécuté de manière itérative, ou exécuté en appliquant une opération de filtre linéaire comme fonction des pressions d'impression détectées.

13. Système d'impression destiné à produire des cellules solaires (250), comprenant :
une première navette d'impression (131) qui présente une surface de support de substrat (137) qui est disposée à une première position ;
une deuxième navette d'impression (131) qui présente une surface de support de substrat qui est disposée à une deuxième position ;
un ou plusieurs détecteurs de position (306, 353) configurés pour détecter une position d'un dispositif d'impression par rapport à la surface de support de substrat de la première navette d'impression ; et
une unité de commande (101) configurée pour commander :
une première opération d'impression au moyen du dispositif d'impression lorsqu'il est disposé relativement à la surface de support de substrat de la première navette d'impression, sachant que la première opération d'impression est exécutée à une première pression d'impression, et
une deuxième opération d'impression au moyen du dispositif d'impression lorsqu'il est disposé relativement à la surface de support de substrat de la deuxième navette d'impression, sachant que la deuxième opération d'impression est exécutée à une deuxième pression d'impression,
sachant que l'unité de commande est en outre configurée pour détecter un écart entre la deuxième pression d'impression et la première pression d'impression, et pour changer la position du dispositif d'impression relativement à la deuxième position pour faire correspondre la deuxième pression d'impression à la première pression d'impression.

14. Le système d'impression de la revendication 13, dans lequel l'unité de commande est configurée pour changer la position du dispositif d'impression relativement à la deuxième position dans une direction verticale.

15. Le système d'impression de la revendication 13 ou 14, comprenant en outre :
un ou plusieurs détecteurs de pression configurés pour détecter la pression exercée par le dispositif d'impression pendant la première opération d'impression et la deuxième opération d'impression.
